# EUROPEAN PATENT APPLICATION

(11) **EP 4 354 570 A2**
(43) Date of publication of application: **17.04.2024**
(21) Application number: 23194378.8
(22) Date of filing: 30.08.2023
(51) Int. Cl.: H01M 10/04, H01M 10/613, H01M 10/647, H01M 10/6551, H01M 10/6553, H01M 50/271, H01M 50/287

(54) **BATTERY PACK INCLUDING HEAT DISSIPATION STRUCTURE**

(30) Priority: 15.09.2022 KR 20220116635
(71) Applicant: Samsung SDI Co., Ltd., Yongin-si, Gyeonggi-do 17084 (KR)
(72) Inventor: PARK, Sanghun, 17084 Yongin-si (KR); HAN, Jongchan, 17084 Yongin-si (KR); JANG, Bongkoun, 17084 Yongin-si (KR)
(74) Representative: Marks & Clerk LLP

(57) **Abstract**

One or more embodiments relate to a battery pack including a heat dissipation structure. The battery pack according to one or more embodiments includes a case, an electrode assembly in the case, and including an electrode tab, a protection circuit module connected to the electrode tab, a fixing bracket at least partially surrounding the protection circuit module, and a heat dissipator outside the fixing bracket and including a heat dissipation element.

## Description

### BACKGROUND

### 1. Field

One or more embodiments relate to a battery pack including a heat dissipation structure.

### 2. Description of the Related Art

Battery packs may have differences depending on their shapes and characteristics. However, each battery pack generally includes an electrode assembly including a positive electrode, a negative electrode, and a separator, and a case for accommodating the electrode assembly. A pouch-type battery pack accommodates an electrode assembly wound in the form of a jelly roll, or an electrode assembly stacked in the form of a stack cell in a case, and includes a protection circuit module for reducing or preventing the likelihood of overcharging, overdischarging, or overcurrent of the battery pack. Also, the battery pack includes a separate case or tape as a fixing bracket for fixing the electrode assembly.

The battery pack may be heated to a relatively high temperature as charging and discharging are repeated. For example, a field effect transistor (FET) of a protection circuit module is the biggest factor of heat emission. Heat generated by an FET is transferred to the entire battery pack as well as a protection circuit module, and may deteriorate the characteristics of the battery pack.

The foregoing background art is technical information that the inventor possessed for derivation of the disclosure or acquired during the derivation process of the disclosure, and cannot necessarily be said to be known art disclosed to the general public prior to filing the disclosure.

### SUMMARY

One or more embodiments include a battery pack that enables heat generated by a field effect transistor in a protection circuit module to be dissipated without it being transferred to the entire battery pack.

However, this is an example, and the disclosure is not limited thereto.

Additional aspects will be set forth in part in the description that follows and, in part, will be apparent from the description, or may be learned by practice of the presented embodiments of the disclosure.

A battery pack according to one or more embodiments includes a case, an electrode assembly in the case, and including an electrode tab, a protection circuit module connected to the electrode tab, a fixing bracket at least partially surrounding the protection circuit module, and a heat dissipator outside the fixing bracket and including a heat dissipation element.

The heat dissipation element may include a pair of elements respectively corresponding to an upper surface of the protection circuit module, and to a lower surface of the protection circuit module.

The heat dissipation element may include a metal layer including aluminium.

The fixing bracket may include a first fixing surface abutting an upper surface of the protection circuit module, a second fixing surface extending downward from an end portion of the first fixing surface, and abutting a side surface of the protection circuit module, and a third fixing surface extending toward the case from an end portion of the second fixing surface, and abutting a lower surface of the protection circuit module, wherein the heat dissipator includes a first heat dissipation surface, a second heat dissipation surface, and a third heat dissipation surface, which respectively correspond to the first fixing surface, the second fixing surface, and the third fixing surface.

The heat dissipation element may be at an interior of the first heat dissipation surface, and is at an interior of the third heat dissipation surface.

Both ends of the first heat dissipation surface may contact one surface of the first fixing surface, and define a heat insulation space between the heat dissipation element and the first heat dissipation surface, wherein both ends of the third heat dissipation surface contact one surface of the third fixing surface, and define a heat insulation space between the heat dissipation element and the third heat dissipation surface.

The heat dissipation element may be at an interior of the second heat dissipation surface.

The protection circuit module may include field effect transistors (FET), wherein the heat dissipator covers the FETs.

The FETs may be inside the heat dissipator in a plan view.

An area of the heat dissipator may be greater than a sum of areas of the FETs.

The heat dissipation element may be detachably arranged on the heat dissipator.

The heat dissipation element may be integrally formed with the heat dissipator to be coplanar with the heat dissipator.

The heat dissipator may contact the fixing bracket.

At least some of the above and other features of the invention are set out in the claims.

Aspects other than those described above will become clear from the detailed description, claims, and drawings for implementing the disclosure below.

### BRIEF DESCRIPTION OF THE DRAWINGS

The above and other aspects of embodiments of the disclosure will be more apparent from the following description taken in conjunction with the accompanying drawings, in which:
FIG. 1 shows an exploded perspective view of a battery pack according to one or more embodiments;
FIGS. 2 and 3 respectively show one side and another side of a protection circuit module according to one or more embodiments;
FIG. 4 shows a front view of a portion of a battery pack according to one or more embodiments;
FIG. 5 shows a cross-sectional view of a battery pack according to one or more embodiments;
FIG. 6 shows a cross-sectional view of a battery pack according to one or more other embodiments; and
FIG. 7 shows a cross-sectional view of a battery pack according to one or more other embodiments.

### DETAILED DESCRIPTION

Aspects of some embodiments of the present disclosure and methods of accomplishing the same may be understood more readily by reference to the detailed description of embodiments and the accompanying drawings. Hereinafter, embodiments will be described in more detail with reference to the accompanying drawings. The described embodiments, however, may have various modifications and may be embodied in different forms, and should not be construed as being limited to only the illustrated embodiments herein. Further, each of the features of the various embodiments of the present disclosure may be combined or combined with each other, in part or in whole, and technically various interlocking and driving are possible. Each embodiment may be implemented independently of each other or may be implemented together in an association. The described embodiments are provided as examples so that this disclosure will be thorough and complete, and will fully convey the aspects of the present disclosure to those skilled in the art, and it should be understood that the present disclosure covers all the modifications, equivalents, and replacements within the idea and technical scope of the present disclosure. Accordingly, processes, elements, and techniques that are not necessary to those having ordinary skill in the art for a complete understanding of the aspects of the present disclosure may not be described.

Unless otherwise noted, like reference numerals, characters, or combinations thereof denote like elements throughout the attached drawings and the written description, and thus, descriptions thereof will not be repeated. Further, parts that are not related to, or that are irrelevant to, the description of the embodiments might not be shown to make the description clear.

In the drawings, the relative sizes of elements, layers, and regions may be exaggerated for clarity. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of regions, but are to include deviations in shapes that result from, for instance, manufacturing.

For example, an implanted region illustrated as a rectangle may have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Thus, the regions illustrated in the drawings are schematic in nature and their shapes are not intended to illustrate the actual shape of a region of a device and are not intended to be limiting. Additionally, as those skilled in the art would realize, the described embodiments may be modified in various ways, all without departing from the scope of the present disclosure.

In the detailed description, for the purposes of explanation, numerous specific details are set forth to provide a thorough understanding of various embodiments. It is apparent, however, that various embodiments may be practiced without these specific details or with one or more equivalent arrangements. In other instances, well-known structures and devices are shown in block diagram form to avoid unnecessarily obscuring various embodiments.

Spatially relative terms, such as "beneath," "below," "lower," "lower side," "under," "above," "upper," "upper side," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or intervening layers, regions, or components may be present. However, "directly connected/directly coupled," or "directly on," refers to one component directly connecting or coupling another component, or being on another component, without an intermediate component. In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expression such as "at least one of A and B" and "at least one of A or B" may include A, B, or A and B. As used herein, "or" generally means "and/or," and the term "and/or" includes any and all combinations of one or more of the associated listed items. For example, the expression such as "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

The terminology used herein is for the purpose of describing particular embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

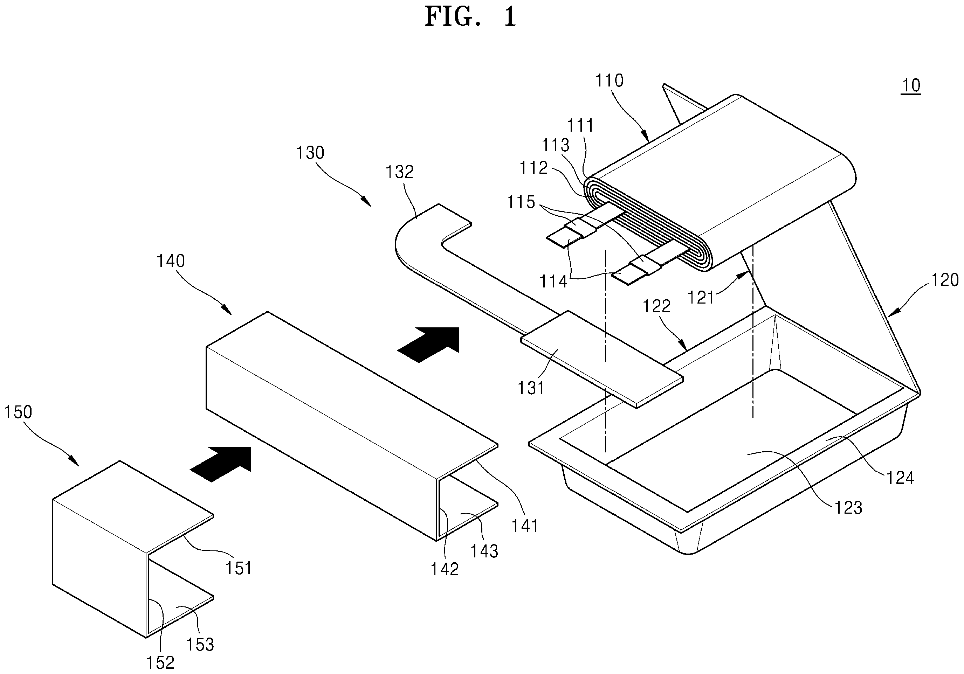

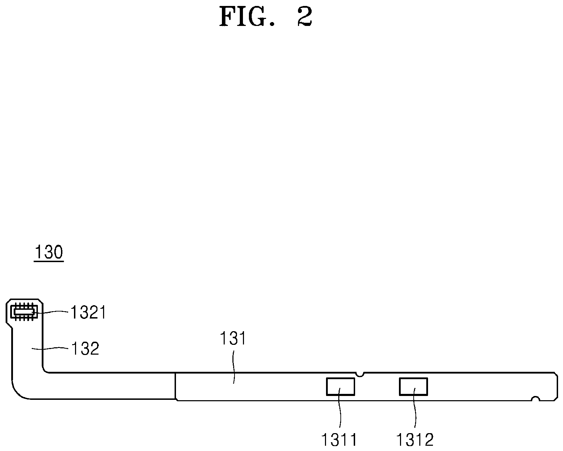

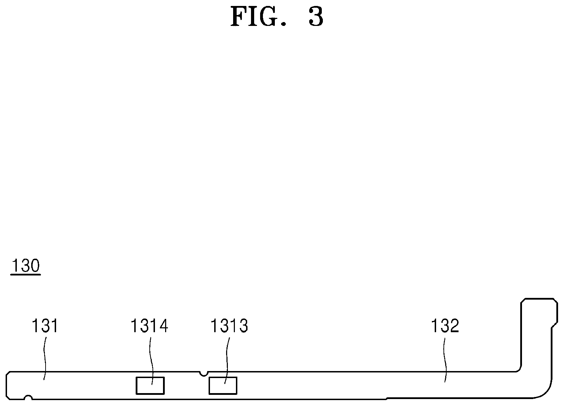

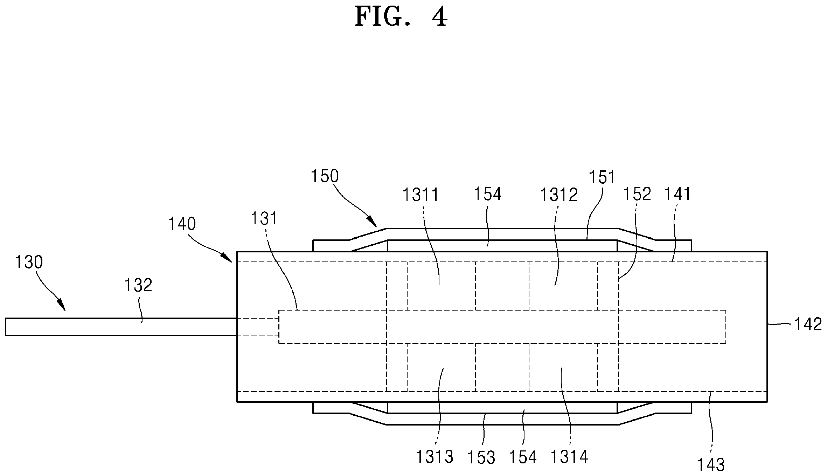

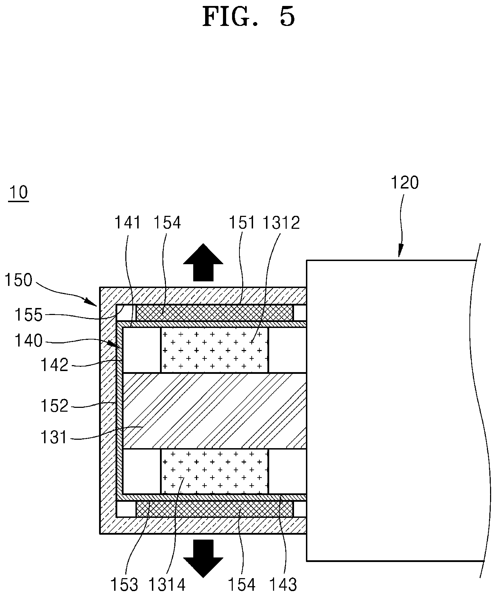

FIG. 1 shows an exploded perspective view of a battery pack 10 according to one or more embodiments, FIGS. 2 and 3 respectively show one side and another side of a protection circuit module 130 according to one or more embodiments, FIG. 4 shows a front view of a portion of the battery pack 10 according to one or more embodiments, and FIG. 5 shows a cross-sectional view of the battery pack 10 according to one or more embodiments.

The battery pack 10 includes an electrode assembly 110, a case 120, a protection circuit module 130, a fixing bracket (e.g., a fixing member) 140, and a heat dissipator (e.g., a heat dissipation member) 150.

The electrode assembly 110 may be manufactured in a jelly roll form by winding a separator 113 arranged between a first electrode plate 111 and a second electrode plate 112. Alternatively, the electrode assembly 110 may be manufactured in a stack form by stacking separators 113 between a plurality of first electrode plates 111 and a plurality of second electrode plates 112. Alternatively, the electrode assembly 110 may be manufactured by applying both a jelly roll and a stack.

The first electrode plate 111 includes a first active material coating portion formed by intermittently coating a first active material on a first substrate, which is a sheet-form conductive material, and a first non-coating portion, which is a portion where the first substrate is exposed without being coated with the first active material. For example, the first electrode plate 111 may be a negative electrode plate, and the first active material may be a negative active material including a carbon material, such as crystalline carbon, amorphous carbon, carbon composite, carbon fiber, or the like, lithium metal, or a lithium alloy.

The second electrode plate 112 includes a second active material coating portion including a polarity that is different from that of the first electrode plate 111. The second electrode plate 112 is formed by intermittently coating a second active material on a second substrate, which is a sheet-form conductive material, and a second non-coating portion, which is a portion where the second substrate is exposed without being coated with the second active material. For example, the second electrode plate 112 may be a positive electrode plate, and the second active material may include a positive electrode active material including lithium, such as LiCoO₂, LiNiO₂, LiMnO₂, LiMn₂O₄, LiNi_{1-x-y}CoₓM_{y}O₂, and/or the like.

The separator 113 is between the first electrode plate 111 and the second electrode plate 112. The separator 113 may insulate the first electrode plate 111 and the second electrode plate 112, and may exchange lithium ions between the first electrode plate 111 and the second electrode plate 112. The separator 113 may have a sufficient length to completely insulate the first electrode plate 111 from the second electrode plate 112 even when the electrode assembly 110 shrinks or expands in a process of charging/discharging the battery pack 10.

Electrode tabs 114 may be respectively arranged on the first electrode plate 111 and the second electrode plate 112 to protrude to one side. For example, two electrode tabs 114 may be provided to respectively correspond to the first electrode plate 111 and the second electrode plate 112. For example, one electrode tab 114 may be electrically connected to one side of the first non-coating portion of the first electrode plate 111 to extend toward the outside of the electrode assembly 110. Also, another electrode tab 114 may be electrically connected to one side of the second non-coating portion of the second electrode plate 112 to extend toward the outside of the electrode assembly 110.

A film portion 115 may be arranged on the electrode tab 114. The film portion 115 is arranged on one surface of the electrode tab 114, or is arranged to surround (e.g., partially surround) the electrode tab 114. The film portion 115 may seal the electrode tab 114 exposed to the outside of the electrode assembly 110. For example, to reduced or prevent the likelihood of a short circuit occurring by contacting the electrode tab 114 with a metal layer exposed at an end portion of a sealing portion 124 of the case 120, which will be described below, the film portion 115 is thermally fused with the sealing portion 124 to cause the electrode tab 114 and the sealing portion 124 to be closely coupled to each other.

The case 120 forms an exterior of the battery pack 10, and the electrode assembly 110 is arranged in the case 120. The shape and size of the case 120 are not particularly limited, and may have a shape and size corresponding to the shape and size of the electrode assembly 110. For example, as shown in FIG. 1, the case 120 may have a rectangular parallelepiped shape with an empty interior. In addition, the case 120 may have a polyhedral shape of another shape, or may have a cylindrical shape.

The case 120 may include a cover 121, a lower case 122, an inner space 123, and the sealing portion 124.

The lower case 122 includes the inner space 123 having a greater size than that of the electrode assembly 110, and the electrode assembly 110 is inserted into the inner space 123. The cover 121 is arranged on an upper surface of the lower case 122 such that it is able to be open and closed, so that the electrode assembly 110 is covered when being inserted into the inner space 123.

The sealing portion 124 is arranged along an upper edge of the lower case 122. As shown in FIG. 1, in a state where the electrode assembly 110 is accommodated inside the case 120, a portion of the electrode tab 114 is exposed to the outside of the case 120. The film portion 115 provided on the electrode tab 114 may be between the cover 121 and the lower case 122 at a position corresponding to the sealing portion 124.

The protection circuit module 130 includes electric circuits and various types of elements for reducing or preventing the likelihood of overcharge, overdischarge, overcurrent, and for reducing or preventing the likelihood of short circuit of the battery pack 10, for example, of the electrode assembly 110. The protection circuit module 130 is arranged outside the case 120, and is connected to the electrode tab 114. For example, as shown in FIG. 1, the protection circuit module 130 is arranged below the electrode tab 114, which may correspond to a cell terrace portion of the battery pack 10.

In one or more embodiments, the protection circuit module 130 includes a substrate 131 and a connector 132. The substrate 131 includes electronic components and circuits for reducing or preventing the likelihood of overdischarge, overcharge, and overcurrent of the battery pack 10, and may be a flexible printed circuit board (FPCB). Also, the connector 132 may be connected to the substrate 131 to connect the protection circuit module 130 to an external device.

As shown in FIGS. 2 and 3, a plurality of field effect transistors (FET) 1311, 1312, 1313, and 1314 may be arranged on the substrate 131. For example, two FETs 1311 and 1312 may be arranged on an upper surface of the substrate 131, and two FETs 1313 and 1314 may be arranged on a lower surface of the substrate 131. These FETs 1311, 1312, 1313, and 1314 control a protection circuit provided on the substrate 131.

The connector 132 extends from one side of the substrate 131 to have a bent end portion. A connection terminal 1321 may be arranged at a distal end portion of the connector 132 to electrically connect the protection circuit module 130 and an external device to each other.

The fixing bracket 140 is mounted on the outside of the case 120 to cover the protection circuit module 130. For example, in a state in which the electrode assembly 110 is mounted inside the case 120, in which the electrode tab 114 is exposed to the outside of the case 120, and in which the electrode tab 114 is connected to the protection circuit module 130, the fixing bracket 140 may be mounted to cover the upper and lower surfaces of the protection circuit module 130. The fixing bracket 140 may protect the protection circuit module 130 from external impact while stably fixing the protection circuit module 130 to the electrode tab 114.

In one or more embodiments, the fixing bracket 140 may have, substantially, a "C" shape (e.g., a bracket shape, "[" shape, or a three-sided, three-dimensional object) to surround or abut at least the upper surface, a side surface, and/or the lower surface of the protection circuit module 130. As shown in FIG. 1, the fixing bracket 140 may include a first fixing surface 141 inserted from the outside of the protection circuit module 130 for covering the upper surface of the protection circuit module 130, a second fixing surface 142 covering a side surface of the protection circuit module 130, and a third fixing surface 143 covering the lower surface of the protection circuit module 130.

As shown in FIGS. 4 and 5, the first fixing surface 141 may be arranged to correspond to the upper surface of the protection circuit module 130, and may contact the FETs 1311 and 1312. The second fixing surface 142 may be bent downward from an end portion of the first fixing surface 141 to contact a side surface (e.g., a left side surface in FIG. 5) of the substrate 131. Also, the third fixing surface 143 may be bent toward the case 120 from an end portion of the second fixing surface 142, and may be arranged to correspond to the lower surface of the substrate 131 to contact the FETs 1313 and 1314. An inner side end portion (e.g., a right-side end portion in FIG. 5) of the fixing bracket 140 may be fixed to the case 120.

In one or more embodiments, the fixing bracket 140 may be fixing tape. The fixing bracket 140 may include an adhesive material on at least the first fixing surface 141, the second fixing surface 142, and/or the third fixing surface 143 to be fixed to the protection circuit module 130.

The heat dissipator 150 is arranged outside of (e.g., at an exterior of, or partially surrounding) the fixing bracket 140 to discharge heat generated by the battery pack 10 to the outside. For example, as shown in FIG. 1, the heat dissipator 150 may be arranged to surround, or abut, an upper surface, a side surface, and a lower surface of the fixing bracket 140.

In one or more embodiments, the heat dissipator 150 may be arranged to surround the protection circuit module 130. For example, as shown in FIGS. 4 and 5, the heat dissipator 150 may be arranged to overlap at least the FETs 1311, 1312, 1313, and/or 1314 arranged on the substrate 131 in a state of being arranged outside the fixing bracket 140. Accordingly, the heat dissipator 150 may discharge heat emitted by the FETs 1311, 1312, 1313, and 1314 to the outside of the battery pack 10.

In one or more embodiments, the heat dissipator 150 may be a heat dissipation tape. Portions of the heat dissipator 150 may be respectively attached to the outside of the upper surface, the side surface, and/or the lower surface of the fixing bracket 140.

In one or more embodiments, the sum of areas of the portions of the heat dissipator 150 may be greater than the sum of areas of the plurality of FETs 1311, 1312, 1313, and 1314.

In one or more embodiments, the heat dissipator 150 may have, substantially, a "C" shape (e.g., a three-sided, three-dimensional object) to surround at least the upper surface, the side surface, and/or the lower surface of the fixing bracket 140. As shown in FIG. 1, the heat dissipator 150 may include a first heat dissipation surface 151 inserted from the outside of the fixing bracket 140 and covering the upper surface of the fixing bracket 140, a second heat dissipation surface 152 covering the side surface of the fixing bracket 140, and a third heat dissipation surface 153 covering the lower surface of the fixing bracket 140.

The first heat dissipation surface 151 may be arranged to correspond to the first fixing surface 141 of the fixing bracket 140. As shown in FIGS. 1, 4, and 5, the first heat dissipation surface 151 may be arranged outside the first fixing surface 141, and may have a smaller area than that of the first fixing surface 141. The first heat dissipation surface 151 may have a greater area than the sum of areas of the FETs 1311 and 1312 arranged on the upper surface of the substrate 131. Also, the FETs 1311 and 1312 may be arranged inside (e.g., at an interior of) the first heat dissipation surface 151 (e.g., may be overlapped by, or entirely overlapped by, the first heat dissipation surface 151). Accordingly, the first heat dissipation surface 151 may absorb heat that is generated by the substrate 131, for example, generated by the FETs 1311 and 1312 arranged on the upper surface of the substrate 131, and that is transferred to the first fixing surface 141 of the fixing bracket 140, to efficiently discharge the heat to the outside of the battery pack 10.

The second heat dissipation surface 152 may be arranged to correspond to the second fixing surface 142 of the fixing bracket 140. As shown in FIGS. 1, 4, and 5, the second heat dissipation surface 152 may be arranged outside the second fixing surface 142, and may have a smaller area than that of the second fixing surface 142. The second heat dissipation surface 152 may extend downward from an end portion of the first heat dissipation surface 151, and may be arranged to cover, or overlap, the FETs 1311, 1312, 1313, and 1314 respectively arranged on an upper portion and a lower portion of the substrate 131. Accordingly, heat that is generated by the FETs 1311, 1312, 1313, and 1314, and that is transferred to the second fixing surface 142 of the fixing bracket 140, may be absorbed to be efficiently discharged to the outside of the battery pack 10.

The third heat dissipation surface 153 may be arranged to correspond to the third fixing surface 143 of the fixing bracket 140. As shown in FIGS. 1, 4, and 5, the third heat dissipation surface 153 may be arranged below the third fixing surface 143, and may have a smaller area than that of the third fixing surface 143. The third heat dissipation surface 153 may extend toward the case 120 from an end portion of the second heat dissipation surface 152, and may be arranged to cover the FETs 1313 and 1314 arranged on the lower portion of the substrate 131.

The third heat dissipation surface 153 may have a greater area than the sum of areas of the FETs 1313 and 1314 arranged on the lower surface of the substrate 131. Also, the FETs 1313 and 1314 may be arranged inside the third heat dissipation surface 153. Accordingly, the third heat dissipation surface 153 may absorb heat that is generated by the substrate 131, for example, generated by the FETs 1313 and 1314 arranged on the lower surface of the substrate 131, and that is transferred to the third fixing surface 143 of the fixing bracket 140, to efficiently discharge the heat to the outside of the battery pack 10.

In one or more embodiments, the heat dissipator 150 further includes a heat dissipation element 154. The heat dissipation element 154 may be arranged on one side of the heat dissipator 150 to absorb heat generated by the protection circuit module 130 to discharge the heat to the outside of the battery pack 10. For example, one or more heat dissipation elements 154 may be arranged on an inner side surface of the heat dissipator 150 to be positioned between the fixing bracket 140 and the heat dissipator 150.

In one or more embodiments, the heat dissipation element 154 may include a material having higher thermal conductivity than that of the fixing bracket 140 and the heat dissipator 150. For example, the heat dissipation element 154 may be a metal layer, and, for example, may be a thin film including aluminium.

In one or more embodiments, the heat dissipation element 154 may be detachably arranged on the heat dissipator 150.

In one or more embodiments, one heat dissipation element 154 may be arranged inside the first heat dissipation surface 151 of the heat dissipator 150, and one heat dissipation element 154 may be arranged inside the third heat dissipation surface 153 of the heat dissipator 150. As shown in FIGS. 4 and 5, the heat dissipation element 154 may be arranged inside the first heat dissipation surface 151 to contact an upper surface of the first fixing surface 141. Also, the heat dissipation element 154 may be arranged inside the third heat dissipation surface 153 to contact a lower surface of the third fixing surface 143. Accordingly, heat generated by the FETs 1311, 1312, 1313, and 1314 may be respectively arranged on the upper surface and lower surface of the substrate 131 to efficiently discharge the heat to the outside of the battery pack 10.

In one or more embodiments, the heat dissipation elements 154 may be symmetrically arranged with the substrate 131 therebetween. As shown in FIGS. 4 and 5, the heat dissipation elements 154 may be respectively arranged to correspond to the upper surface and the lower surface of the substrate 131 and may be arranged to overlap each other.

In one or more embodiments, the heat dissipation element 154 may have a greater area than the areas of the FETs 1311, 1312, 1313, and 1314. For example, an area of the heat dissipation element 154 arranged on the first heat dissipation surface 151 may be greater than the sum of areas of the FETs 1311 and 1312 arranged on the upper surface of the substrate 131. Also, the FETs 1311 and 1312 may be arranged inside the first heat dissipation surface 151. Also, an area of the heat dissipation element 154 arranged on the third heat dissipation surface 153 may be greater than the sum of areas of the FETs 1313 and 1314 arranged on the lower surface of the substrate 131. Accordingly, heat generated by the FETs 1311, 1312, 1313, and 1314 may be stably discharged to the outside of the battery pack 10 through the heat dissipation element(s) 154 without being transferred to the battery pack 10.

In one or more embodiments, in a state where the first heat dissipation surface 151 and the third heat dissipation surface 153 are arranged outside the fixing bracket 140, the heat dissipation element 154 may be inserted therebetween. For example, as shown in FIGS. 4 and 5, the heat dissipation element 154 may have a smaller area than that of the first heat dissipation surface 151 and the third heat dissipation surface 153. Accordingly, both ends of the first heat dissipation surface 151 contact one surface of the first fixing surface 141, and both ends of the third heat dissipation surface 153 contact one surface of the third fixing surface 143. Also, the first heat dissipation surface 151 and the third heat dissipation surface 153 may each have a shape surrounding the heat dissipation element 154, and a heat insulation space 155 may be partitioned by the first to third heat dissipation surfaces 151 to 153, the heat dissipation element 154, and the fixing bracket 140. The heat insulation space 155 may perform an insulation function so that heat transferred from the FETs 1311, 1312, 1313, and 1314 is not transferred to the battery pack 10.

Through this configuration, the battery pack 10 according to one or more embodiments may efficiently discharge heat generated by the protection circuit module 130, for example, generated by the FETs 1311, 1312, 1313, and 1314, to the outside of the battery pack 10 through the heat dissipation element 154.

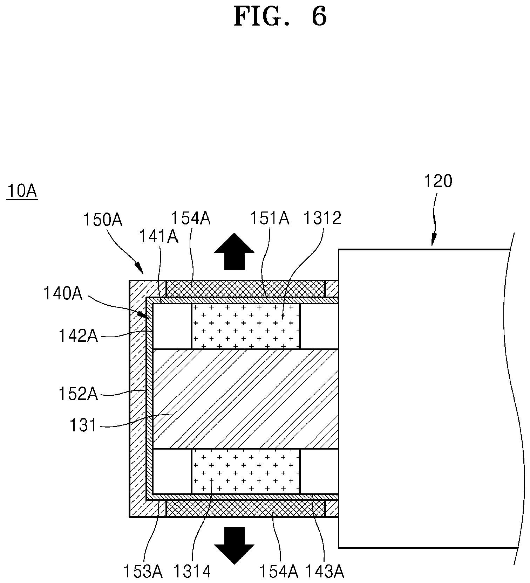

FIG. 6 shows a cross-sectional view of a battery pack 10A according to one or more other embodiments.

The battery pack 10A may include a different heat dissipator 150A compared to the battery pack 10 according to the above-described embodiments. Other configurations of the battery pack 10A may be the same as those of the battery pack 10, and detailed descriptions thereof are omitted.

The battery pack 10A includes the heat dissipator 150A. As shown in FIG. 6, the heat dissipator 150A may include a first heat dissipation surface 151A, a second heat dissipation surface 152A, and a third heat dissipation surface 153A, which are arranged outside the fixing bracket 140 and the first to third fixing surfaces 141A to 143A, and are positioned to respectively correspond to a first fixing surface 141A, a second fixing surface 142A, and a third fixing surface 143A of the fixing bracket 140A.

In one or more embodiments, the battery pack 10A includes a heat dissipation element 154A. As shown in FIG. 6, the heat dissipation element 154A may be integrally formed with the heat dissipator 150A. That is, unlike the heat dissipation element 154 according to the embodiments described above, which is additionally arranged inside each of the first heat dissipation surface 151 and the third heat dissipation surface 153, the heat dissipation element 154A according to one or more embodiments may be integrally formed with the heat dissipator 150A to replace a partial area of (e.g., to be coplanar with) the heat dissipator 150A, for example, a partial area(s) of the first heat dissipation surface 151A and/or the third heat dissipation surface 153A. Accordingly, the heat dissipator 150A may be arranged in closer contact with the fixing bracket 140 without a gap.

For example, as shown in FIG. 6, as the heat dissipation element 154A is integrally formed with the first heat dissipation surface 151A and the third heat dissipation surface 153A, entire surfaces of the first heat dissipation surface 151A and the third heat dissipation surface 153A, each including the heat dissipation element 154A, may be in close contact with the fixing bracket 140. Accordingly, the heat dissipator 150A may be more firmly fixed to the fixing bracket 140, and heat transferred to the fixing bracket 140 may be transferred to the heat dissipator 150A without loss.

In one or more embodiments, both surfaces of the heat dissipation element 154A may include a transparent material. For example, a lower surface of the heat dissipation element 154A, which faces the fixing bracket 140, and an upper surface corresponding to the lower surface, may all include a transparent material.

In one or more other embodiments, the heat dissipation element 154A may include one surface including a transparent material, and another surface including an opaque material. For example, the heat dissipation element 154A may include a lower surface including a transparent material, and an upper surface including an opaque material. On the contrary, the heat dissipation element 154A may include an upper surface including a transparent material and a lower surface including an opaque material.

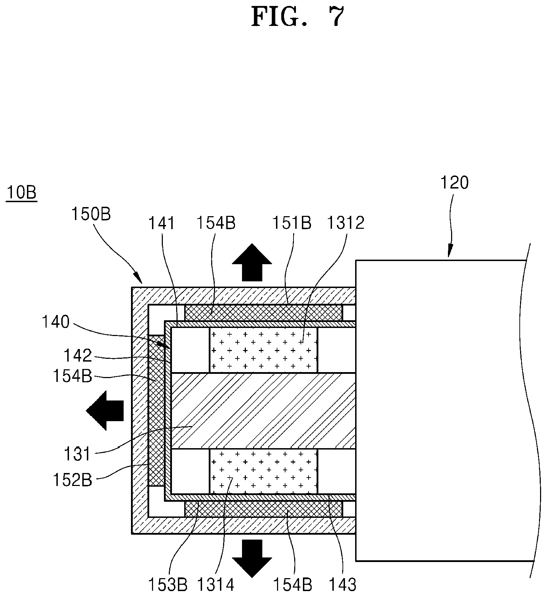

FIG. 7 shows a cross-sectional view of a battery pack 10B according to one or more other embodiments.

The battery pack 10B includes a different heat dissipator 150B compared to the battery pack 10 according to the above-described embodiments. Other configurations of the battery pack 10B may be the same as those of the battery pack 10, and detailed descriptions thereof are omitted.

The battery pack 10B includes the heat dissipator 150B. As shown in FIG. 7, the heat dissipator 150B may include a first heat dissipation surface 151B, a second heat dissipation surface 152B, and a third heat dissipation surface 153B, which are arranged outside the fixing bracket 140 and are positioned to respectively correspond to the first fixing surface 141, the second fixing surface 142, and the third fixing surface 143 of the fixing bracket 140.

In one or more embodiments, the battery pack 10B includes a heat dissipation element 154B. As shown in FIG. 7, the heat dissipation element 154B may be arranged inside each of the first heat dissipation surface 151B, the second heat dissipation surface 152B, and the third heat dissipation surface 153B. That is, unlike the heat dissipation element 154 according to the embodiments described above, which is additionally arranged inside each of the first heat dissipation surface 151 and the third heat dissipation surface 153, the heat dissipation element 154B according to the one or more embodiments may be additionally arranged inside (e.g., at an interior of) the second heat dissipation surface 152B. Accordingly, heat generated by side surfaces of the protection circuit module 130 may not flow into the battery pack 10B and may be discharged to the outside of the battery pack 10B through the heat dissipation element 154B arranged on the second heat dissipation surface 152B.

As such, the disclosure has been described with reference to the embodiments shown in the drawings only as examples. While the disclosure has been shown and described with reference to embodiments thereof, it will be understood by those of ordinary skill in the art that various changes in form and details may be made therein without departing from the scope as defined by the following claims.

Technical details described in the embodiments are examples, and do not limit the technical scope of the embodiments. For the sake of brevity, description of general techniques and configurations in the related art may be omitted. Furthermore, the connecting lines, or connectors shown in the various figures presented are intended to represent functional relationships and/or physical or logical couplings between the various elements, as examples. It should be noted that many alternative or additional functional relationships, physical connections or logical connections may be present in a practical device. Moreover, no item or component is essential to the practice of the present disclosure unless the element is specifically described as "essential" or "critical".

The use of the terms "a" and "an" and "the" and similar referents in the context of describing the disclosure and claims are to be construed to cover both the singular and the plural. Furthermore, recitation of ranges of values herein are merely intended to serve as a shorthand method of referring individually to each separate value falling within the range, unless otherwise indicated herein, and each separate value is incorporated into the specification as if it were individually recited herein. Also, the steps of all methods described herein can be performed in any suitable order unless otherwise indicated herein or otherwise clearly contradicted by context. The disclosure is not limited to the described order of the steps. The use of any and all examples, or exemplary language (e.g., "such as") provided herein, is intended merely to better illuminate the present disclosure and does not pose a limitation on the scope of the present disclosure unless otherwise claimed. Numerous modifications and adaptations will be readily apparent to one of ordinary skill in the art without departing from the scope.

A battery pack according to one or more embodiments includes a heat dissipation structure, so that heat generated by a protection circuit module, for example, by an FET, may be discharged to the outside with being transferred to the battery pack.

A battery pack according to one or more embodiments may implement a compact heat dissipation structure without increasing, or without substantially increasing, the size of the battery pack through a thin film heat dissipator.

A battery pack according to one or more embodiments may efficiently discharge heat generated by an FET by arranging a heat dissipation element to correspond to the FET.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the disclosure as defined by the following claims, with functional equivalents thereof to be included therein.

## Claims

1. A battery pack comprising:
a case;
an electrode assembly in the case, and comprising an electrode tab;
a protection circuit module connected to the electrode tab;
a fixing bracket at least partially surrounding the protection circuit module; and
a heat dissipator outside the fixing bracket and comprising a heat dissipation element.

2. The battery pack of claim 1, wherein the heat dissipation element comprises a pair of elements respectively corresponding to an upper surface of the protection circuit module, and to a lower surface of the protection circuit module.

3. The battery pack of claim 1 or claim 2, wherein the heat dissipation element comprises a metal layer comprising aluminium.

4. The battery pack of any one of claims 1 to 3, wherein the fixing bracket comprises:
a first fixing surface abutting an upper surface of the protection circuit module;
a second fixing surface extending downward from an end portion of the first fixing surface, and abutting a side surface of the protection circuit module; and
a third fixing surface extending toward the case from an end portion of the second fixing surface, and abutting a lower surface of the protection circuit module, and
wherein the heat dissipator comprises a first heat dissipation surface, a second heat dissipation surface, and a third heat dissipation surface, which respectively correspond to the first fixing surface, the second fixing surface, and the third fixing surface.

5. The battery pack of claim 4, wherein the heat dissipation element is at an interior of the first heat dissipation surface, and is at an interior of the third heat dissipation surface.

6. The battery pack of claim 5, wherein both ends of the first heat dissipation surface contact one surface of the first fixing surface, and define a heat insulation space between the heat dissipation element and the first heat dissipation surface, and
wherein both ends of the third heat dissipation surface contact one surface of the third fixing surface, and define a heat insulation space between the heat dissipation element and the third heat dissipation surface.

7. The battery pack of claim 5 or claim 6, wherein the heat dissipation element is at an interior of the second heat dissipation surface.

8. The battery pack of any one of claims 1 to 7, wherein the protection circuit module comprises field effect transistors (FET), and
wherein the heat dissipator covers the FETs.

9. The battery pack of claim 8, wherein the FETs are inside the heat dissipator in a plan view.

10. The battery pack of claim 9, wherein an area of the heat dissipator is greater than a sum of areas of the FETs.

11. The battery pack of any one of claims 1 to 10, wherein the heat dissipation element is detachably arranged on the heat dissipator.

12. The battery pack of any one of claims 1 to 4, wherein the heat dissipation element is integrally formed with the heat dissipator to be coplanar with the heat dissipator.

13. The battery pack of claim 12, wherein the heat dissipator contacts the fixing bracket.
